# EUROPEAN PATENT APPLICATION

(11) **EP 4 525 576 A1**
(43) Date of publication of application: **19.03.2025**
(21) Application number: 23834465.9
(22) Date of filing: 21.04.2023
(51) Int. Cl.: H05K 7/20, F25B 49/02, F25B 41/42, F25B 41/24, H02M 1/00

(54) **FREQUENCY CONVERTER COOLING DEVICE, COOLING METHOD AND AIR CONDITIONING APPARATUS**

(30) Priority: 08.07.2022 CN 202210806051
(71) Applicant: Gree Electric Appliances, Inc. of Zhuhai, Zhuhai, Guangdong 519070 (CN)
(72) Inventor: LI, Long, Zhuhai, Guangdong 519070 (CN); CHENG, Qi, Zhuhai, Guangdong 519070 (CN); PENG, Boyu, Zhuhai, Guangdong 519070 (CN); ZHONG, Hailing, Zhuhai, Guangdong 519070 (CN); ZHOU, Jin, Zhuhai, Guangdong 519070 (CN)
(74) Representative: Appleyard Lees IP LLP
(86) International application number: PCT/CN2023/089832
(87) International publication number: WO 2024/007685

(57) **Abstract**

The present disclosure provides a variable frequency drive cooling device, a cooling method, and an air conditioning apparatus. The variable frequency drive cooling device includes an inlet conduit, an outlet conduit equipped with a first electric valve, a first branch pipe and a second branch pipe connected in parallel between the inlet conduit and the outlet conduit, the first branch pipe being configured to cool a variable frequency drive cabinet, and the second branch pipe being configured to cool a variable frequency drive module; a bypass, one end of the bypass communicating with an outlet pipe a compressor, and another end of the bypass communicating with an outlet of the first electric valve in the outlet conduit, the bypass being equipped with a second electric valve and an ejector; and a third branch pipe, one end of the third branch pipe communicating with the ejector, and another end of the third branch pipe communicating with an inlet of the first electric valve, the third branch pipe being equipped with a third electric valve.

## Description

### CROSS-REFERENCE TO RELATED APPLICATIONS

This application is based upon and claims priority to Chinese patent application No. 202210806051.8, filed on July 8, 2022. The content of the CN application is hereby incorporated herein in its entity by reference.

### TECHNICAL FIELD

The present disclosure relates to the field of air conditioning technology, particularly to a variable frequency drive cooling device, a cooling method, and air conditioning apparatus using the variable-frequency drive cooling device.

### BACKGROUND

During the operation of a variable frequency refrigeration compressor unit, the variable frequency drive may experience an abnormal temperature rise when running under harsh operation conditions for a long period of time. The variable frequency drive needs to be cooled to ensure normal operation. A conventional method for cooling a variable frequency drive involves providing additional heat dissipation devices, such as using fans to cool the variable frequency drive. Another cooling method involves introducing a portion of refrigerant from the refrigeration cycling system to cool the variable frequency drive and lower the temperature thereof. Related art discloses a variable frequency drive cooling system that uniformly cools the variable frequency drive. This cooling system introduces two refrigerant flow paths from the condenser outlet to cool both the variable frequency drive cabinet and the variable frequency drive module, to address the issue of cooling the variable frequency drive in a refrigeration unit under conventional operating conditions.

### SUMMARY

The technical solutions adopted in the present disclosure are as follows.

A variable frequency drive cooling device is provided, and includes: an inlet conduit, one end of the inlet conduit communicating with an outlet pipe of a condenser; an outlet conduit equipped with a first electric valve, one end of the outlet conduit communicating with an inlet pipe of an evaporator; a first branch pipe and a second branch pipe, which are connected in parallel between the inlet conduit and the outlet conduit, wherein the first branch pipe is configured to cool a variable frequency drive cabinet, and the second branch pipe is configured to cool a variable frequency drive module. The variable frequency drive cooling device further includes a bypass and a third branch pipe. One end of the bypass communicates with an outlet pipe a compressor, and the other end of the bypass communicates with an outlet of the first electric valve in the outlet conduit. The bypass is equipped with a second electric valve and an ejector. One end of the third branch pipe communicates with the ejector, and the other end of the third branch pipe communicates with an inlet of the first electric valve. The third branch pipe is equipped with a third electric valve.

In some embodiments, the first branch pipe is further equipped with a fourth electric valve and includes a capillary tube.

In some embodiments, the second branch pipe is provided with a fifth electric valve, and a branch pipe is connected in parallel to two ends of the fifth electric valve, and the branch pipe is equipped with an electronic expansion valve.

The present disclosure further provides an air conditioning apparatus, including the above-described variable frequency drive cooling device.

The present disclosure further provides a variable frequency drive cooling method for the above-mentioned air conditioning apparatus. The method controls communication between the outlet conduit and the bypass based upon an environmental temperature, a variable frequency drive in-cabinet temperature, a variable frequency drive module temperature, and/or a compressor operating frequency, forcefully ejecting refrigerant flow through the ejector under high-temperature and low-frequency conditions, thereby ensuring the cooling effect for the variable frequency drive.

In some embodiments, the variable frequency drive cooling method includes: in a starting state of the unit, controlling opening and closing of the bypass according to a first preset strategy based on an environmental temperature and a preset high-temperature value for environmental temperature; in a normal operating state of the unit, controlling the opening and closing of the bypass according to a second preset strategy based on a variable frequency drive in-cabinet temperature, a variable frequency drive module temperature, and preset maximum values respectively for variable frequency drive in-cabinet temperature and for variable frequency drive module temperature; and in a low-frequency operating state of the unit, controlling the opening and closing of the bypass according to a third preset strategy based on a compressor operating frequency, a preset compressor operating minimum frequency, and a preset compressor low-frequency value

In some embodiments, controlling according to the first preset strategy includes: when the environmental temperature is lower than the preset high-temperature value for environmental temperature, closing the bypass, such that the refrigerant from the first branch pipe and the second branch pipe merges at outlets and directly flows through the first electric valve to the evaporator; when the environmental temperature is higher than or equal to the preset high-temperature value for environmental temperature, opening the bypass, such that the refrigerant from the first branch pipe and the second branch pipe merges at the outlets , flows through the third electric valve and the ejector to merge with the refrigerant from the bypass, and then flows to the outlet conduit.

In an embodiment, the controlling according to the first preset strategy includes the following steps: in the starting state of the unit, detecting the environmental temperature T, and determining whether the environmental temperature T is lower than the preset high-temperature value for environmental temperature T_{K1}; if true, opening the fourth electric valve, the fifth electric valve, the first electric valve, and the electronic expansion valve within t₁ minutes before the compressor starts, allowing the unit to enter a normal operating state; and if false, opening the fourth electric valve, the third electric valve, the second electric valve, and the electronic expansion valve within t₁ minutes before the compressor starts, stabling a flow rate of the refrigerant cooling the variable frequency drive by the bypass and the ejector, and after t₂ minutes from the compressor starts, opening the fifth electric valve and the first electric valve, and closing the third electric valve and the second electric valve, allowing the unit to enter the normal operating state.

In some embodiments, the controlling according to the second preset strategy includes: when the variable frequency drive in-cabinet temperature is lower than the preset maximum value for in-cabinet temperature and the variable frequency drive module temperature is lower than the preset maximum value for variable frequency drive module temperature, closing the bypass, such that the refrigerant from the first and second branch pipes merges at the outlets and directly flows through the outlet conduit to the evaporator; and when the variable frequency drive in-cabinet temperature is higher than or equal to the preset maximum value for in-cabinet temperature and the variable frequency drive module temperature is higher than or equal to the preset maximum value for variable frequency drive module temperature, opening the bypass, such that the refrigerant from the first and second branch pipes merges at the outlets, flows through the third electric valve and the ejector to merge with the refrigerant from the bypass, and then flows through the outlet conduit to the evaporator.

In some embodiments, controlling according to the second preset strategy includes the following steps: after t₂ minutes from the compressor starts, detecting the variable frequency drive in-cabinet temperature T_{G} and the variable frequency drive module temperature T_{M} in real time, and determining whether the variable frequency drive in-cabinet temperature T_{G} is lower than the preset maximum value for in-cabinet temperature T_{K2} and whether the variable frequency drive module temperature T_{M} is lower than the preset maximum value for variable frequency drive module temperature T_{K3}; if true, opening the fifth electric valve and the first electric valve, and closing the third electric valve and the second electric valve, so that the bypass is closed; if false, closing the fifth electric valve and the first electric valve, and opening the third electric valve and the second electric valve, so that the bypass is open.

In some embodiments, the controlling according to the third preset strategy includes the following steps: after t₂ minutes from the compressor starts, detecting the compressor operating frequency and determining whether the compressor operating frequency being greater than or equal to the preset compressor operating minimum frequency and less than or equal to the preset compressor low-frequency value persists continuously for t₃ minutes; if true, opening the third electric valve and the second electric valve, so that the bypass is open, and closing the fifth electric valve and the first electric valve; and if false, opening the fifth electric valve and the first electric valve, so that the bypass is closed.

In some embodiments, when after controlling according to either the second preset strategy or the third preset strategy enters a bypass forced cooling control stage, controlling according to the other strategy is not executed until the unit returns to the normal operating state.

In some embodiments, when the controlling according to the second preset strategy and the controlling according to the third preset strategy conflict, the second preset strategy has a priority on controlling the opening and closing of the bypass.

The present disclosure further provides a non-transitory computer-readable storage medium storing a computer program, which, when read by a processor, is configured to execute the above-described variable frequency drive cooling method.

According to another aspect of the present disclosure, a variable frequency drive cooling device is provided, including a memory and a processor. The process is coupled to the memory, and the processor is configured to execute the above-described variable frequency drive cooling method on a basis of instructions stored in the memory.

According to another aspect of the present disclosure, a computer program is provided, and includes instructions, which, when executed by a processor, are configured to cause the processor to perform the above-described variable frequency drive cooling method.

### BRIEF DESCRIPTION OF THE DRAWINGS

The drawings that form part of the specification illustrate embodiments of the present disclosure and are adopted in combination with the specification to explain the principles of the present disclosure.

The present disclosure is specifically described with reference to the drawings and specific embodiments, where:
FIG. 1 is a systemic view of the present disclosure;
FIG. 2 is a flowchart of controlling based on a first preset strategy in a variable frequency drive cooling control method of the present disclosure;
FIG. 3 is a flowchart of controlling based on a second preset strategy in the variable frequency drive cooling control method of the present disclosure;
FIG. 4 is a flowchart of controlling based on a third preset strategy in the variable frequency drive cooling control method of the present disclosure; and
FIG. 5 is a schematic structural view of some embodiments of a variable frequency drive cooling control device of the present disclosure.

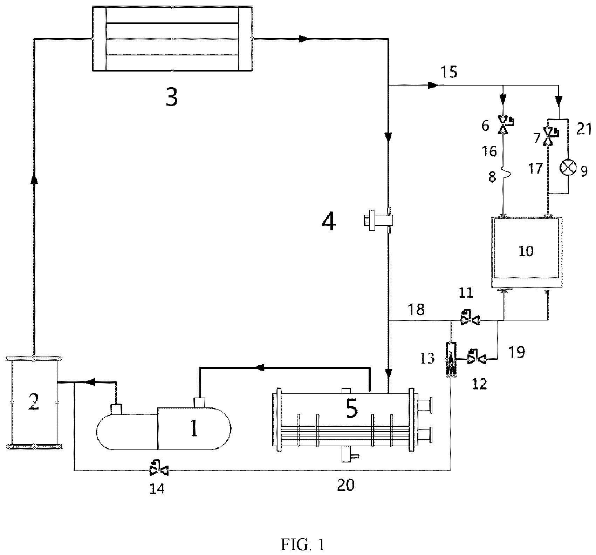

In FIG. 1:
1 - Compressor, 2 - Oil separator, 3 - Condenser, 4 - Throttling device, 5 - Evaporator, 6 - Fourth electric valve, 7 - Fifth electric valve, 8 - Capillary tube, 9 - Electronic expansion valve, 10 - Variable frequency drive, 11 - First electric valve, 12 - Third electric valve, 13 - Ejector, 14 - Second electric valve, 15 - Inlet conduit, 16 - First branch pipe, 17 - Second branch pipe, 18 - Outlet conduit, 19 - Third branch pipe, 20 - Bypass, 21 - Branch pipe.

In the flowcharts:
T - Environmental temperature, T_{K1} - Preset high-temperature value for environmental temperature, T_{G} - Variable frequency drive in-cabinet temperature, T_{M} - Variable frequency drive module temperature, T_{K2} - Preset high-temperature value for variable frequency drive in-cabinet temperature, T_{K3} - Preset high-temperature value for variable frequency drive module temperature;
t₁ - Time interval before compressor starts, t₂ - Time interval after compressor starts, t₃ - Continuous detection time;
f - Compressor operating frequency, f₁ - Preset compressor operating minimum frequency, f_{d} - Preset compressor low-frequency value.

It should be understood that the dimensions of the various parts shown in the drawings are not necessarily drawn to scale. In addition, identical or similar reference numerals represent the same or similar components.

### DETAILED DESCRIPTION

Various exemplary embodiments of the present disclosure will now be described in detail with reference to the accompanying drawings. It should be noted that unless otherwise specifically indicated, the relative arrangement, numerical expressions, and values of the components and steps described in these embodiments do not limit the scope of the present disclosure.

In addition, it should be understood that for ease of description, the dimensions of the various parts shown in the drawings are not drawn to scale.

The following description of at least one exemplary embodiment is merely illustrative and should not be construed as any limitation on the disclosure or its applications or uses.

The technologies, methods, and equipment that are well known to those skilled in the related art may not be discussed in detail, but, where appropriate, such technologies, methods, and equipment should be considered part of the specification.

In all the examples shown and discussed herein, any specific values should be interpreted as merely examples and not as limitations. Therefore, other examples of the exemplary embodiments may have different values.

It should be noted that similar reference numerals and letters in the following drawings represent similar items. Thus, once an item is defined in one drawing, it needs no further discussion in the subsequent drawings.

To make the objectives, technical solutions, and advantages of the present disclosure clearer, the following detailed description is provided in combination with the drawings and embodiments. It should be understood that the following specific embodiments are for explanatory purposes only and do not limit the scope of the disclosure.

Using fans to cool the variable frequency drive increases the spatial structure of the variable frequency drive, raises costs, and results in suboptimal cooling performance. Introducing a portion of the refrigerant from the refrigeration cycling system to cool the variable frequency drive is another approach. However, high-temperature conditions (at environmental temperatures of 43°C to 52°C) may exist in actual operation of air-cooled chillers. Under the high-temperature conditions, there may be insufficient or no refrigerant flowing through the variable frequency drive cooling path, leading to an overheating risk of the variable frequency drive. Additionally, when the compressor operates at a low frequency for a long period of time, the high-low pressure differential of the system is small, which can also reduce the amount of refrigerant flowing through the variable frequency drive cooling path, resulting in insufficient refrigerating capacity to lower the temperature of the variable frequency drive.

Referring to FIG. 1, a variable frequency refrigeration cycling system includes: a compressor 1, an oil separator 2, a condenser 3, a throttling device 4, and an evaporator 5, which are sequentially communicated via piping. The high-temperature and high-pressure refrigerant discharged from the compressor 1 is filtered to remove lubricating oil through the oil separator 2, and then cooled into a medium-temperature and high-pressure liquid in the condenser 3. After passing through the throttling device 4, the refrigerant becomes a low-temperature and low-pressure liquid, then evaporates into a low-temperature and low-pressure gas in the evaporator 5, and returns to the compressor 1 for circulation. To meet various load requirements, the compressor typically is a variable frequency compressor, and the variable frequency drive needs to be cooled to ensure its normal operation.

A variable frequency drive cooling device provided by the present disclosure includes an inlet conduit 15. One end of the inlet conduit 15 communicates with an outlet pipe of the condenser 3, and the other end of the inlet conduit 15 communicates with a first branch pipe 16 and a second branch pipe 17, respectively. The first branch pipe 16 and the second branch pipe 17 are connected in parallel. The first branch pipe 16 passes through the variable frequency drive cabinet and then communicates with an outlet conduit 18. The second branch pipe 17 passes through the variable frequency drive module and then communicates with the outlet conduit 18. The other end of the outlet conduit 18 communicates with an inlet pipe of the evaporator 5. The outlet conduit 18 is equipped with a first electric valve 11.

The first branch pipe 16 is configured to cool the variable frequency drive cabinet, and is equipped with a fourth electric valve 6. The fourth electric valve 6 is configured to control whether refrigerant flows through the first branch pipe 16 or not by opening or closing, thereby regulating whether the variable frequency drive cabinet needs to be cooled or not.

In some embodiments, the first branch pipe further includes a capillary tube 8 configured to control a pressure difference between an inlet and an outlet of the first branch pipe, limiting a flow rate of the refrigerant flowing through the first branch pipe and enhancing a heat exchange effect.

In some embodiments, the portion of the first branch pipe within the variable frequency drive cabinet is closely attached to an inner sidewall of the cabinet and is arranged in a serpentine shape.

The second branch pipe 17 is configured to cool the variable frequency drive module. The second branch pipe 17 is equipped with a fifth electric valve 7. The fifth electric valve 7 is configured similarly to control whether refrigerant flows through the second branch pipe or not by opening or closing, thereby regulating whether the variable frequency drive module needs to be cooled or not.

In some embodiments, a branch pipe 21 is parallelly connected to two ends of the fifth electric valve 7. The branch pipe 21 is equipped with an electronic expansion valve 9. The refrigerant flow rate in the second branch pipe can be regulated by adjusting an opening degree of the electronic expansion valve.

In some embodiments, the portion of the second branch pipe within the cabinet is closely attached to the variable frequency drive module. When the temperature of the variable frequency drive module is higher than a threshold value, the refrigerant flow rate is reduced, lowering the temperature of the refrigerant passing the variable frequency drive module, which improves the heat exchange effect between the second branch pipe and the variable frequency drive module, thereby accelerating the cooling rate of the variable frequency drive module. When the temperature of the variable frequency drive module is lower than or equal to a threshold value, the refrigerant flow rate is reduced, and the amount of refrigerant flowing through the second branch pipe decreases, which reduces the heat exchange effect, thereby decelerating the cooling rate of the variable frequency drive module.

Under a high-temperature condition, that is the temperature being higher than a temperature threshold value, e.g., the environmental temperature exceeds 43°C, or when the compressor operates at a low frequency for a relatively long period of time, that is the compressor frequency being lower than a frequency threshold value, e.g., the compressor frequency is below 40% of the rated frequency, there may be insufficient refrigerant or even no refrigerant flowing through the variable frequency drive cooling path, leading to an overheating risk of the variable frequency drive. To address this issue, in the present disclosure, a bypass 20 and a third branch pipe 19 are additionally arranged in the above-described variable frequency drive cooling device. One end of the bypass communicates with an outlet pipe of the compressor, and the other end of the bypass communicates with an outlet of the first electric valve 11 in the outlet conduit 18. The bypass 20 is sequentially equipped with a second electric valve 14 and an ejector 13. The third branch pipe 19 is equipped with a third electric valve 12. One end of the third branch pipe communicates with the ejector 13, and the other end of the third branch pipe communicates with an inlet of the first electric valve 11. The ejector 13 functions as a power-generating component, allowing the ejecting fluid introduced from the bypass to apply work on the ejected fluid from the third branch pipe 19, thereby increasing the energy of the fluid form the third branch pipe 19. In other words, the ejector creates a suction effect on the refrigerant in the first and second branch pipes, thereby increasing and stabilizing the refrigerant flow rate in the first and second branch pipes, ensuring the cooling effect of the variable frequency drive cabinet and module.

In some embodiments, the communication between the outlet conduit and the bypass is controlled based upon at least one of an environmental temperature, a variable frequency drive in-cabinet temperature, a variable frequency drive module temperature, or a compressor operating frequency. Under the high-temperature and low-frequency conditions, the refrigerant is introduced through the bypass and the ejector, thereby ensuring the cooling performance for the variable frequency drive.

A variable frequency drive cooling method provided by the present disclosure includes: in a starting state of the unit, controlling opening and closing of the bypass according to a first preset strategy based on an environmental temperature and a preset high-temperature value for environmental temperature; in a normal operating state of the unit, controlling opening and closing of the bypass according to a second preset strategy based on a variable frequency drive in-cabinet temperature, a variable frequency drive module temperature, and preset maximum values respectively for variable frequency drive in-cabinet temperature and for variable frequency drive module temperature; and in a low-frequency operating state of the unit, controlling opening and closing of the bypass according to a third preset strategy based on a compressor operating frequency, a preset compressor operating minimum frequency, and a preset compressor low-frequency value.

The controlling according to the first preset strategy is applied in the starting state of the unit, and includes: when the environmental temperature is lower than the preset high-temperature value for environmental temperature, close the bypass 20, such that the refrigerant from the first branch pipe 16 and the second branch pipe 17 merges at the outlets and flows through the outlet conduit 18 to the evaporator 5; when the environmental temperature is higher than or equal to the preset high-temperature value for environmental temperature, open the bypass 20, such that the refrigerant from the first branch pipe 16 and the second branch pipe 17 merges at the outlets, flows through the third electric valve 12 and the ejector 13 to merge with the refrigerant from the bypass, and then flows through the outlet conduit 18 to the evaporator 5.

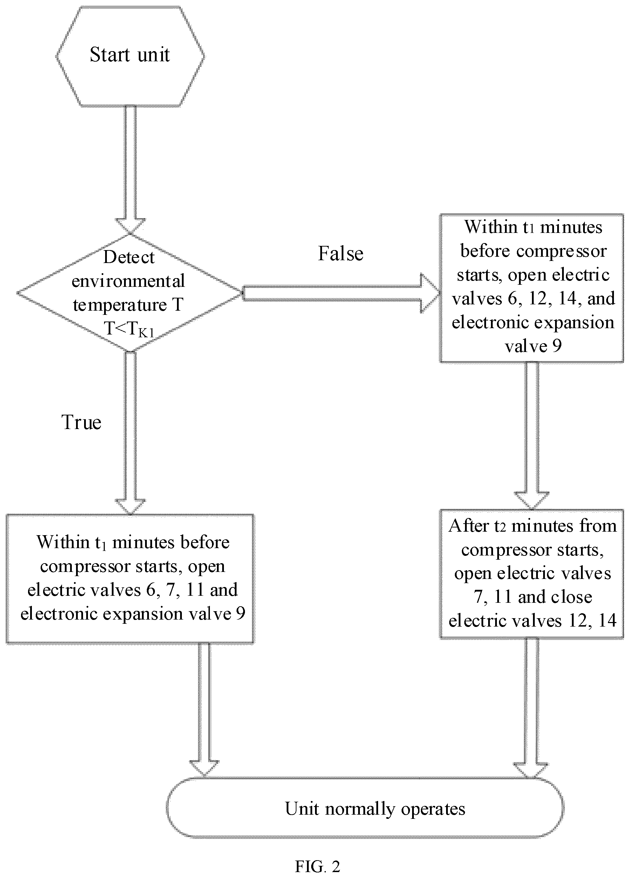

As shown in FIGs. 1 and 2, the controlling according to the first preset strategy includes the following steps.

In the starting state of the unit, detect the environmental temperature T, and determine whether the environmental temperature T is lower than the preset high-temperature value for environmental temperature T_{K1}.

When the environmental temperature T is detected to be lower than the preset high-temperature value for environmental temperature T_{K1}, cool the variable frequency drive according to a conventional control, which is to open the fourth electric valve 6, the fifth electric valve 7, the first electric valve 11, and the electronic expansion valve 9 within t₁ minutes before the compressor starts. ① Main refrigerant flow path of the unit is: 1 → 2 → 3 → 4 → 5 → 1; ② Cooling refrigerant flow path for variable frequency drive cabinet is: 1 → 2 → 3 → 6 → 8 → 10 → 11 → 5 → 1; ③ Cooling refrigerant flow path for variable frequency drive module is: 1 → 2 → 3 → 7,9 → 10 → 11 → 5 → 1.

When the environmental temperature T is detected to be higher than or equal to the preset high-temperature value for environmental temperature T_{K1}, the environmental temperature is too high, and there is a risk of overheating in the variable frequency drive cabinet and the variable frequency drive module. On this condition, open the bypass 20, so that the bypass and the ejector 13 can forcefully eject the refrigerant flow to ensure cooling of the variable frequency drive. Within t₁ minutes before the compressor starts, open the fourth electric valve 6, the third electric valve 12, the second electric valve 14, and the electronic expansion valve 9, by which, following paths are formed:
① Main refrigerant flow path of the unit: 1 → 2 → 3 → 4 → 5 → 1;
② Cooling refrigerant flow path for variable frequency drive cabinet: 1 → 2 → 3 → 6 → 8 → 10 → 12 → 13 → 5 → 1;
③ Cooling refrigerant flow path for variable frequency drive module: 1 → 2 → 3 → 7,9 → 10 → 12 → 13 → 5 → 1;
④ Bypass refrigerant flow path: 1 → 14 → 13 → 5 → 1.

After t₂ minutes from the compressor starts and when the refrigerant stabilizes, open the fifth electric valve 7 and the first electric valve 11 first, and then close the third electric valve 12 and the second electric valve 14, so that the variable frequency drive is cooled according to conventional control of the refrigerant flow path.

The controlling according to the second preset strategy control is applied in the normal operating state of the unit, and includes: when the variable frequency drive in-cabinet temperature is lower than the preset maximum value for in-cabinet temperature, and when the variable frequency drive module temperature is less than the preset maximum value for variable frequency drive module temperature, close the bypass, such that the refrigerant from the first and second branch pipes merges at the outlets and directly flows to the outlet conduit; and when the variable frequency drive in-cabinet temperature is higher than or equal to the preset maximum value for in-cabinet temperature, and when the variable frequency drive module temperature is higher than or equal to the preset maximum value for variable frequency drive module temperature, open the bypass, such that the refrigerant from the first and second branch pipes merges at the outlets, and then flows through the ejector to merge with the refrigerant from the bypass, and then flows to the outlet conduit.

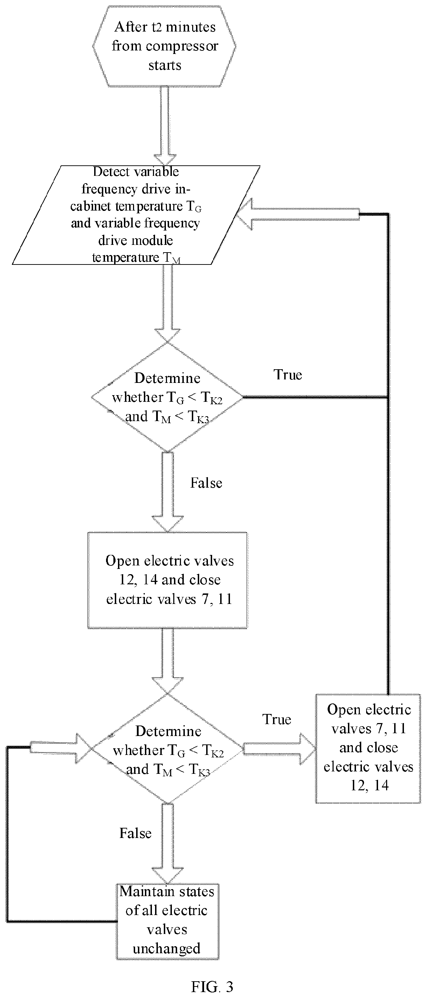

As shown in FIGs. 1 and 3, the controlling according to the second preset strategy includes the following steps.

After t₂ minutes from the compressor starts, detect the variable frequency drive in-cabinet temperature T_{G} and the variable frequency drive module temperature T_{M}, and determine whether the variable frequency drive in-cabinet temperature T_{G} is lower than the preset maximum value for in-cabinet temperature T_{K2} and whether the variable frequency drive module temperature T_{M} is lower than the preset maximum value for variable frequency drive module temperature T_{K3}, i.e., determine whether T_{G} < T_{K2} and T_{M} < T_{K3}.

If the result of determination is true, maintain the open or close states of the electric valves unchanged (i.e., the fourth electric valve 6, the fifth electric valve 7, the electronic expansion valve 9, and the first electric valve 11 remain open, while the third electric valve 12 and the second electric valve 14 remain closed), maintain the refrigerant flow path unchanged, and go back to the detection and determination steps involving the variable frequency drive in-cabinet temperature T_{G} and the variable frequency drive module temperature T_{M}.

If the result of determination is false, open the third electric valve 12, the second electric valve 14, and the electronic expansion valve 9 to open the bypass 20, and close the fifth electric valve 7 and the first electric valve 11.

Then again detect the variable frequency drive in-cabinet temperature T_{G} and the variable frequency drive module temperature T_{M}, and determine whether T_{G} < T_{K2} and T_{M} < T_{K3}.

If the result of determination is true, open the fifth electric valve 7 and the first electric valve 11, and close the third electric valve 12 and the second electric valve 14, so that the refrigerant flow path is the same as the refrigerant flow path in the normal state when the bypass 20 is closed; then go back to the detection and determination steps involving the variable frequency drive in-cabinet temperature T_{G} and the variable frequency drive module temperature T_{M}.

If the result of determination is false, maintain the states of the electric valves unchanged, maintain the refrigerant flow path unchanged, and go back to the detection and determination steps.

The controlling according to the third preset strategy is applied in the low-frequency operating state of the compressor, and includes: open the bypass when the compressor operating frequency is greater than or equal to the preset compressor operating minimum frequency and less than or equal to the preset compressor low-frequency value; and close the bypass when the compressor operating frequency is less than the preset compressor operating minimum frequency and greater than the preset compressor low-frequency value.

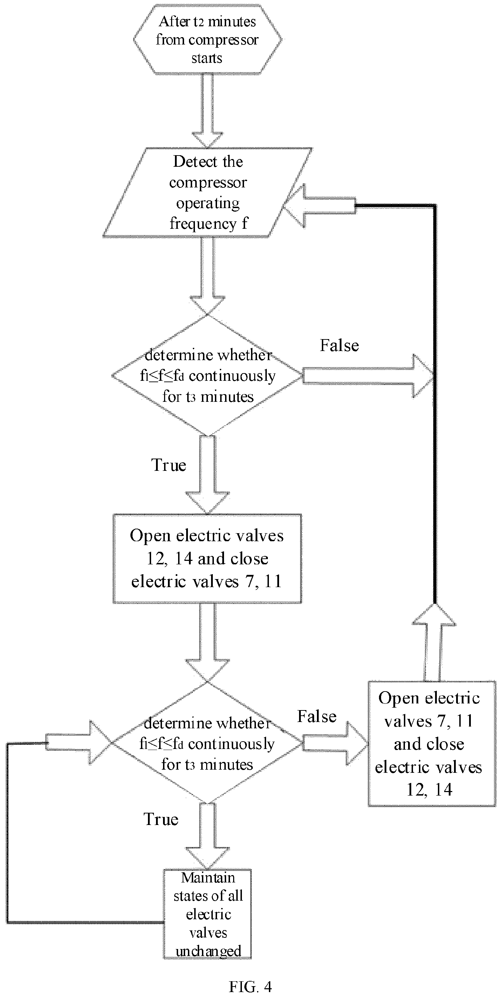

As shown in FIGs. 1 and 4, the controlling according to the third preset strategy includes the following steps:

After t₂ minutes from the compressor starts, detect the compressor operating frequency f and determine whether the compressor operating frequency f satisfies f₁≤f≤f_{d} continuously for t₃ minutes.

If the result of determination is false, maintain the states of the electric valves unchanged, so that the bypass is closed, and then go back to the detection and determination steps involving the compressor operating frequency f.

If the result of determination is true, open the third electric valve 12 and the second electric valve 14, so that the bypass is opened, and close the fifth electric valve 7 and the first electric valve 11, so that the refrigerant from the outlet of the variable frequency drive and the refrigerant from the bypass flow through the ejector 13 and then flow to the evaporator 5, and then go back to the detection and determination steps involving the compressor operating frequency f, i.e., determine whether the compressor operating frequency f satisfies f₁≤f≤f_{d} continuously for t₃ minutes.

If the result of determination is true, maintain the states of the electric valves unchanged, and continue the detection and determination involving the compressor operating frequency, during which the fifth electric valve 7 and the first electric valve 11 remain closed, while the third electric valve 12 and the second electric valve 14 remain open, with the refrigerant from the outlet of the variable frequency drive and the refrigerant from the bypass flowing through the ejector and then flowing to the evaporator.

If the result of determination is false, open the fifth electric valve 7 and the first electric valve 11, and close the third electric valve 12 and the second electric valve 14, so that the bypass is closed, and then go back to the detection and determination steps involving the compressor operating frequency.

The execution priority between the controlling according to the second preset strategy and the controlling according to the third preset strategy is decided by following steps: after the controlling according to either the second preset strategy or the third preset strategy enters a bypass forced cooling control stage (i.e., when the third electric valve 12 and the second electric valve 14 are open, and the fifth electric valve 7 and the first electric valve 11 are closed), the controlling according to the other strategy is not executed until the system returns to the normal state.

When the controlling according to the second preset strategy and the controlling according to the third preset strategy conflict, the second preset strategy has a priority on controlling the opening and closing of the bypass.

In the present disclosure, the bypass and the ejector are additionally arranged in the system, thereby ensuring that under harsh operation conditions, refrigerant in the cooling flow path for the variable frequency drive can circulate steadily, guaranteeing effective cooling for the variable frequency drive under high temperature and low-frequency conditions.

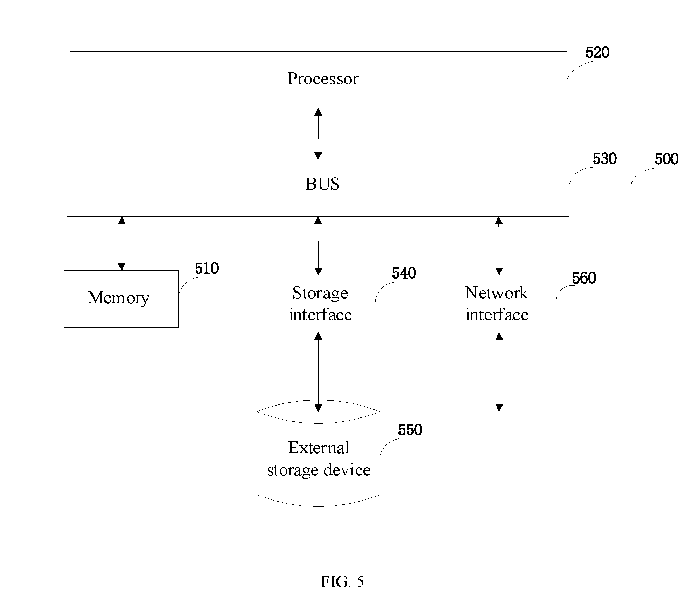

FIG. 5 is a schematic structural view of some embodiments of a variable frequency drive cooling controlling device of the present disclosure. The variable frequency drive cooling controlling device 500 includes a memory 510 and a processor 520. Specifically, the memory 510 can be a disk, a flash memory, or any other non-volatile storage medium. The memory 510 is configured to store the instructions for implementing the above embodiments. The processor 520 is coupled to the memory 510 and can be one or more integrated circuits, such as a microprocessor or microcontroller. The processor 520 is configured to execute the instructions stored in the memory.

In some embodiments, the processor 520 is coupled to the memory 510 via a bus 530. In some embodiments, the variable frequency drive cooling control device 500 is also connected to an external storage device 550 via a storage interface 540 to retrieve external data. In some embodiments, the variable frequency drive cooling control device 500 is connected to a network or another computer system (not shown) via a network interface 560, which is not specifically elaborated herein.

In these embodiments, by storing the instructions as data in the memory and executing the instructions via the processor, the effective cooling for the variable frequency drive under the high temperature and low-frequency conditions can be ensured.

The variable frequency drive cooling control method provided in the present disclosure can be stored in a computer-readable storage medium. When the program stored on the computer-readable storage medium is read by a processor, the variable frequency drive cooling control method is executed. The skilled person in the art can understand that the embodiments of the present disclosure can be provided as a method, an apparatus, or a computer program product. Therefore, the present disclosure can be implemented entirely by hardware, entirely by software, or by a combination of both hardware and software. Furthermore, the present disclosure can be implemented in the form of a computer program product on one or more computer-readable non-transitory storage media (including but not limited to disk storage, CD-ROM, optical storage, etc.) containing computer-readable program codes.

In some embodiments, a computer program is provided, and includes instructions, which, when executed by a processor, cause the processor to perform the above-described variable frequency drive cooling control method.

The above described are merely specific embodiments of the present disclosure. It should be noted that any modifications, equivalent substitutions, or variations made within the spirit and scope of the present disclosure should all be included within the protection scope of the present disclosure.

## Claims

1. A variable frequency drive cooling device comprising:
an inlet conduit, one end of the inlet conduit communicating with an outlet pipe of a condenser;
an outlet conduit equipped with a first electric valve, one end of the outlet conduit communicating with an inlet pipe of an evaporator;
a first branch pipe and a second branch pipe, connected in parallel between the inlet conduit and the outlet conduit, the first branch pipe being configured to cool a variable frequency drive cabinet, and the second branch pipe being configured to cool a variable frequency drive module;
a bypass, one end of the bypass communicating with an outlet pipe a compressor, and another end of the bypass communicating with an outlet of the first electric valve in the outlet conduit, the bypass being equipped with a second electric valve and an ejector; and
a third branch pipe, one end of the third branch pipe communicating with the ejector, and another end of the third branch pipe communicating with an inlet of the first electric valve, the third branch pipe being equipped with a third electric valve.

2. The variable frequency drive cooling device according to claim 1, wherein the first branch pipe is equipped with a fourth electric valve and comprises a capillary tube.

3. The variable frequency drive cooling device according to claim 1, wherein the second branch pipe is provided with a fifth electric valve.

4. The variable frequency drive cooling device according to claim 3, wherein a branch pipe is connected in parallel to two ends of the fifth electric valve, and the branch pipe is equipped with an electronic expansion valve.

5. An air conditioning apparatus comprising the variable frequency drive cooling device according to any one of claims 1 to 4.

6. A variable frequency drive cooling method for the air conditioning apparatus according to claim 5, comprising:
controlling communication between the outlet conduit and the bypass based upon at least one of an environmental temperature, a variable frequency drive in-cabinet temperature, a variable frequency drive module temperature, and a compressor operating frequency; and
ejecting refrigerant flow through the ejector and the bypass under high-temperature and low-frequency conditions.

7. The variable frequency drive cooling method according to claim 6, further comprising:
in a starting state of the air conditioning apparatus, controlling opening and closing of the bypass according to a first preset strategy based on an environmental temperature and a preset high-temperature value for environmental temperature;
in a normal operating state of the air conditioning apparatus, controlling the opening and closing of the bypass according to a second preset strategy based on the variable frequency drive in-cabinet temperature, the variable frequency drive module temperature, and preset maximum values respectively for variable frequency drive in-cabinet temperature and for variable frequency drive module temperature; and
in a low-frequency operating state of the air conditioning apparatus, controlling the opening and closing of the bypass according to a third preset strategy based on the compressor operating frequency, a preset compressor operating minimum frequency, and a preset compressor low-frequency value.

8. The variable frequency drive cooling method according to claim 7, wherein controlling according to the first preset strategy comprises:
on a condition that the environmental temperature is lower than the preset high-temperature value for environmental temperature, closing the bypass, such that refrigerant from the first branch pipe and the second branch pipe merges at outlets and directly flows through the first electric valve to the evaporator; and
on a condition that the environmental temperature is higher than or equal to the preset high-temperature value for environmental temperature, opening the bypass, such that the refrigerant from the first branch pipe and the second branch pipe merges at the outlets , flows through the third electric valve and the ejector to merge with refrigerant from the bypass, and then flows through the outlet conduit to the evaporator.

9. The variable frequency drive cooling method according to claim 8, wherein controlling according to the first preset strategy includes following steps:
in the starting state of the unit, detecting the environmental temperature T, and determining whether the environmental temperature T is lower than the preset high-temperature value for environmental temperature T_{K1};
on a condition that the environmental temperature T is lower than the preset high-temperature value for environmental temperature T_{K1}, opening the fourth electric valve, the fifth electric valve, the first electric valve, and the electronic expansion valve within t₁ minutes before the compressor starts, allowing the unit to enter a normal operating state; and
on a condition that the environmental temperature T is higher than or equal to the preset high-temperature value for environmental temperature T_{K1}, opening the fourth electric valve, the third electric valve, the second electric valve, and the electronic expansion valve within t₁ minutes before the compressor starts, stabling a flow rate of refrigerant cooling the variable frequency drive by the bypass and the ejector, and after t₂ minutes from the compressor starts, opening the fifth electric valve and the first electric valve and closing the third electric valve and the second electric valve, allowing the unit to enter the normal operating state.

10. The variable frequency drive cooling method according to claim 7, wherein controlling according to the second preset strategy comprises:
on a condition that the variable frequency drive in-cabinet temperature is lower than the preset maximum value for in-cabinet temperature and the variable frequency drive module temperature is lower than the preset maximum value for variable frequency drive module temperature, closing the bypass, such that refrigerant from the first and second branch pipes merges at outlets and directly flows through the outlet conduit to the evaporator; and
on a condition that the variable frequency drive in-cabinet temperature is higher than or equal to the preset maximum value for in-cabinet temperature and the variable frequency drive module temperature is higher than or equal to the preset maximum value for variable frequency drive module temperature, opening the bypass, such that the refrigerant from the first and second branch pipes merges at the outlets, flows through the third electric valve and the ejector to merge with refrigerant from the bypass, and then flows through the outlet conduit to the evaporator.

11. The variable frequency drive cooling method according to claim 10, wherein controlling according to the second preset strategy comprises following steps:
after t₂ minutes from the compressor starts, detecting the variable frequency drive in-cabinet temperature T_{G} and the variable frequency drive module temperature T_{M};
determining whether the variable frequency drive in-cabinet temperature T_{G} is lower than the preset maximum value for in-cabinet temperature T_{K2} and whether the variable frequency drive module temperature T_{M} is lower than the preset maximum value for variable frequency drive module temperature T_{K3},
on a condition that the variable frequency drive in-cabinet temperature T_{G} is lower than the preset maximum value for in-cabinet temperature T_{K2} and the variable frequency drive module temperature T_{M} is lower than the preset maximum value for variable frequency drive module temperature T_{K3}, opening the fifth electric valve and the first electric valve, and closing the third electric valve and the second electric valve, so that the bypass is closed;
on a condition that the variable frequency drive in-cabinet temperature T_{G} is higher than or equal to the preset maximum value for in-cabinet temperature T_{K2} or the variable frequency drive module temperature T_{M} is higher than or equal to the preset maximum value for variable frequency drive module temperature T_{K3}, closing the fifth electric valve and the first electric valve, and opening the third electric valve and the second electric valve, so that the bypass is open.

12. The variable frequency drive cooling method according to claim 7, wherein controlling according to the third preset strategy comprises following steps:
after t₂ minutes from the compressor starts, detecting the compressor operating frequency and determining whether the compressor operating frequency is greater than or equal to the preset compressor operating minimum frequency and less than or equal to the preset compressor low-frequency value continuously for t₃ minutes;
on a condition that the compressor operating frequency being greater than or equal to the preset compressor operating minimum frequency and smaller than or equal to the preset compressor low-frequency value persists continuously for t₃ minutes, opening the third electric valve and the second electric valve, so that the bypass is open, and closing the fifth electric valve and the first electric valve; and
on a condition that the compressor operating frequency being smaller than the preset compressor operating minimum frequency or greater than the preset compressor low-frequency value persists continuously for t₃ minutes, opening the fifth electric valve and the first electric valve, so that the bypass is closed.

13. The variable frequency drive cooling method according to claim 7, wherein after controlling according to either the second preset strategy or the third preset strategy enters a bypass forced cooling control stage, controlling according to the other strategy is not executed until the unit returns to the normal operating state.

14. The variable frequency drive cooling method according to claim 7, wherein when controlling according to the second preset strategy and controlling according to the third preset strategy conflict, the second preset strategy has a priority on controlling the opening and closing of the bypass.

15. A non-transitory computer-readable storage medium storing a computer program, which, when read by a processor, is configured to execute the variable frequency drive cooling method according to any one of claims 6 to 14.

16. A variable frequency drive cooling device, comprising:
a memory; and
a processor,
wherein the process is coupled to the memory, and the processor is configured to execute the variable frequency drive cooling method according to any one of claims 6 to 14 on a basis of instructions stored in the memory.

17. A computer program comprising instructions, which, when executed by a processor, are configured to cause the processor to perform the variable frequency drive cooling method according to any one of claims 6 to 14.
